# EUROPEAN PATENT APPLICATION

(11) **EP 2 367 020 A1**
(43) Date of publication of application: **21.09.2011**
(21) Application number: 10155445.9
(22) Date of filing: 04.03.2010
(51) Int. Cl.: G01R 33/345

(54) **Targeted traveling wave MRI**

(71) Applicant: Deutsches Krebsforschungszentrum (DKFZ), 69120 Heidelberg (DE)
(72) Inventor: Umathum, Reiner, 69115 Heidelberg (DE); Alt, Stefan, 61197 Florstadt (DE); Müller, Marco, 75438 Knittlingen (DE); Bock, Michael, 69126 Heidelberg (DE)
(74) Representative: Hörschler, Wolfram Johannes

(57) **Abstract**

The present invention relates to a travelling wave MRI apparatus which comprises a coaxial waveguide arrangement consisting of a continuous cylindrical outer shield and two axially spaced apart hollow cylindrical inner conductive tubes between which the investigation area is located. For reducing the attenuation of the travelling wave in portions of a patient outside the region of interest, and thereby reducing also the global SAR, unexposed portions of the patient are positioned in the hollow interior of the inner conductive tubes so as to shield them from the propagating wave.

## Description

### Prior Art

NMR signal detection is traditionally based on Faraday induction in one or multiple radio-frequency resonators. These are brought to close proximity with the sample to be analysed. Alternative principles involve structured material flux guides, superconducting quantum interference devices, atomic magnetometers, Hall probes or magnetoresistive elements. A common feature of all NMR-implementations until now is that they rely on close coupling between detector and object under investigation. The publication "Travelling-wave nuclear magnetic resonance" of David O. Brunner, Nicola De Zanche, Jürg Fröhlich, Jan Paska und Klaas P. Pruessmann, Vol. 457, 19. Februar 2009, doi:10.1038/nature07752 shows that NMR (nuclear magnetic resonance) can also be excited and detected by long-range interaction, relying on travelling radio frequency (RF) waves, sent and received by an antenna. One benefit of this approach is more uniform coverage of samples that are larger than the wavelength of the MRI signal - an important current issue in MRI of humans at very high magnetic fields. By allowing a significant distance between the probe and the sample, travelling wave interaction also introduces new possibilities in the design of MRI experiments and systems.

Uniform spatial coverage in MRI is traditionally achieved by tailoring the near field of resonant probes. The approach is valid when the RF wavelength at the Larmor frequency is substantially larger than the targeted structure, which does not hold for modem, wide-bore, high-field systems. At the highest field strength currently used for human studies, 9.4 T, the Larmor frequency of hydrogen nuclei is 400 MHz, corresponding to a wavelength in tissue in the order of 10 cm. At such short wavelengths, head or body resonators form standing-wave field patterns, which degrade MRI results by causing regional field nonuniformity through interference effects. In the case of transmission, these field inhomogenities induce changes in contrast throughout the image, thus impeding diagnostics

A travelling wave concept can reduce these interference effects. In addition, travelling radio-frequency waves offer a natural means of exciting and detecting NMR across large distances.

Despite these features, travelling-wave NMR has not been explored so far. In traditional cylindrical imaging devices, the propagation of travelling waves at the NMR frequency is usually not supported by the geometry and the electrical properties of the structures surrounding the sample, such as gradient coils, cryostats, and radio-frequency screens. Their conductive surfaces admit axially travelling waves only beyond a cut-off frequency that is approximately inversely proportional to the bore width. Therefore, travelling-wave NMR requires a high-field magnet that also has a wide bore to bring the cut-off frequency below the NMR frequency, as well as a conductive surface lining the bore.

WO 2009/127431 Al is related to a travelling-wave nuclear magnetic resonance method. A method for acquiring an image or spectrum of a subject or object is disclosed, residing within the magnetic field of a magnetic resonance apparatus. First, a predetermined pulse sequence is executed for applying gradient magnetic fields and for coupling in electromagnetic excitation pulses to induce nuclear magnetic resonance within the subject or object. Then an electromagnetic signal resulting from said magnetic resonance is detected and at least one image or magnetic resonance spectrum is constructed of said subject or object from said detected electromagnetic signals. The coupling in of the electromagnetic excitation pulse and/or detecting of the electromagnetic signal is carried out substantially by means of travelling electromagnetic waves. According to WO 2009/127431 Al the subject or object is located within a cavity of the magnetic resonance apparatus and wherein the travelling electromagnetic waves are axially travelling electromagnetic waves in said cavity, preferably within an elongated tubular structure having an electrically conducting wall. Said cavity has a low cut off frequency when loaded with the subject or object to be imaged and is smaller than said operating frequency.

The publication "Effective delivery of the travelling-wave to distant locations in the body at 7 T", International Society Mag. Reson. Med. 17, 2009, page 501, relates to the application of the travelling-wave concept to MRI experiments. In MRI experiments excitation and reception are carried out by a single antenna situated at the beginning of a cavity of a 7 T MR-scanner which guides travelling-waves along its longitudinal axis. The radiated travelling-wave first travels through air and then propagates (partly) in a (human) body. A strong damping of the wave occurs during the passage through the body and prohibits excitation of the parts which are located far from the antenna.

According to this publication a new concept is presented to deliver a maximum B₁ power to the intended region for RF excitation using a waveguide with a coaxial inner conductor. Such waveguide is created by the RF shield of the MR-scanner or an inserted conductive surface, and the inserted cylinder conductive layer which encloses part of the body such as the legs. Due to this inner conductor, the wave initially does not penetrate into the enclosed parts of the body and, thus, the undesirable wave attenuation is avoided.

Nuclear magnetic resonance imaging (MRI) in particular for imaging of selected portions of a patient or another object has so far relied on two main categories of radiofrequency (RF) coils as generally described in US 4,920,318. The first type is a volume resonator dimensioned to be placed around the entire object or patient to be imaged or around a portion thereof. The other type of coil is generally formed by wrapping wire or other conductors on a flat dielectric sheet shaped in such a way as to be positionable close to the portion to be imaged.

There is a strong trend in MRI technology to go to higher static magnetic field strengths. The benefits of these higher magnetic fields are a stronger intrinsic signal due to the stronger magnetisation, increased contrast mechanisms such as BOLD or phase contrast and greater spectral separation for spectroscopic imaging. Since MRI is generally a technique limited by signal-to-noise ratio (SNR), the increase in SNR in contrast achievable by increasing the static magnetic field strength enables higher spatial and temporal resolution.

However, an increase in static magnetic field strength requires a proportional increase in operating radio frequency. As a consequence, the wavelength of the RF is shortened correspondingly. For example, the vacuum wavelength of the RF used on a 7 T-system is about 1 m, and it is about 10 cm in human tissue due to the high permittivity of the material.

Moreover, the probe design becomes more intricate because resonator design suffers from reduced robustness due to variable loading in in-vivo applications and because current distributions on the conductive structures of the probe are hardly predictable.

Finally, safety aspects become very intricate due to the strong coupling between sample and probe. RF-induced heating is one of the major concerns, especially at higher frequencies. Slight changes of patient geometry next to the probe conductors may crucially change the situation, worst case scenarios are hard to determine. Safety validation issues thus become a time consuming step in the development of new MRI probes, particularly for transmitting probes.

In order to diminish negative effects of phenomenoms concerning the standing waves in high magnetic- field MRI, two methods have been established so far.
1. Parallel transmission:
   In contrast to conventional MRI methods where the high frequency coils are being excited by only one high frequency transmission unit, a high frequency excitation with the parallel transmission technique is being performed using several local coils and independent transmission units. If the phases and amplitudes of each transmission unit are modulated correctly, inhomogenities can be minimized and a more uniform deposition of energy can be achieved within the object to be investigated, e.g. the human body.
2. Travelling-wave:
   Concerning the solution disclosed in the abstract of Brunner et al., i.e. "Travelling-wave-method", a travelling high frequency wave is being coupled into the tomographic device,
   the geometry of which is shaped such that the travelling-wave is being transmitted within the hollow interior of a cylinder with minimum attenuation. In contrast to using high frequency resonators, this does not result in a pattern of standing waves as long as within the volume to be investigated reflections of the waves are suppressed. As disclosed by Brunner et al., the travelling-wave is coupled into the tomographic device, which serves as a hollow conductive member being filled with ambient air. However, this results in the disadvantage that this concept is only applicable for frequencies above a certain cut-off-frequency. For typically used magnet bore diameter of about 60cm this limiting frequency is approximately of 300 MHz, which also corresponds to the Larmor frequency of protons at 7 T. In particular this prohibits the use of this technology for lower Larmor frequencies, e.g. when using other nuclei (e.g. ²³NA).

### Summary of the invention

It is the principle objective of the present invention to provide for coupling in high frequency waves into an object to be investigated particularly in an area of interest without exposing areas of non-interest, i.e. not to be investigated with high frequency waves.

One significant component of MRI is a high frequency coil by means of which a RF field is coupled into the subject or object to be investigated, particularly the human body, to provide for a measurement of the magnetic state, particularly the area of interest which is exposed to the RF field. In contrast to the prior art, such as sketched above, the present invention discloses a particular high frequency device which enables to couple in RF waves targeted into a particular section of interest of the object to be investigated without exposing other areas of the object to RF waves. This offers the advantage that the excluded parts are not unnecessarily exposed to the RF waves and do not contribute to RF exposure limit calculations, which allows for a coupling in of a larger dose of the RF energy at a location where it is required.

In contrast to solutions according to the prior art, the present invention discloses a MRI device having a coaxial arrangement of a first conductive member and a second conductive member, whereas according to the solutions discussed above, tubular elements are being used as conductive members. The MRI device according to the present invention having a first and a second conductive member arranged in a coaxial arrangement with respect to one another comprises a continuous conductive tubular outer member and a tubular shaped inner conductive member, which is divided in axial direction and an investigation area being comprised in this division.

This division defines the area of investigation of the object to be measured, particularly a human body of a patient to be examined with MRI. The two halves of the inner conductive member enclose the sections of the objects not to be investigated, particularly sparing parts of the human body from the RF field which is only guided through the investigation area, i.e. into the part of the object to be investigated where the RF field is to be coupled in.

The electrical connection of the coaxial arrangement of the MRI device according to the present invention is located at both outer ends. Alternatively, the electrical connection could be established anywhere within the gap between the inner and outer conductive members. Since the RF device according to the present invention is symmetrical, a transmission of the waves to be coupled into the coaxial arrangement according to the present invention, in general is possible in both directions. The coaxial arrangement according to the present invention is used for spectroscopic measurements and is used in terms of magnetic resonance imaging operations. In an advantageous embodiment according to the present invention the area of investigation, i.e. the gap between the two halves of the inner conductive member, is of variable length. Particularly seen in axial direction, the halves of the inner electrical conductive member are arranged moveable in axial direction, so as to allow for variable space, i.e. an investigation area of variable axial length. Still further, seen in radial direction, the annular walls surrounding the object to be investigated, e.g. parts of a human body, are flexible to allow for accommodation of objects of different shape and size, e.g. human beings with a larger waist-size.

The enclosing realized by said halves of the inner conductive member allows for individual investigation areas and allows an adapting of the investigation area as well as an exclusion of those parts of the human body which should not be exposed to the RF field being transmitted by the MRI device according to the present invention having a substantially coaxial arrangement of two conductive members.

Using this coaxial arrangement according to the present invention, the field distribution creating aforementioned inhomogenities are being minimized and a more homogeneous excitation is achieved.

The coaxial arrangement according to the present invention of a MRI device uses the concept of the travelling waves, however limits the disadvantages thereof. Concerning the concept of Brunner et al., as briefly discussed above, always an excitation of the entire object to be investigated, i.e. the entire human body, located within the hollow interior of the tube, is performed. Thus, no specific investigation area is being established, i.e. the entire human body is exposed to the RF field. Still further, a disadvantageous effect lies in the fact that the excitation intensity is dependent on the absorption of the object seen from the entry of the travelling waves in direction of the exit of the travelling waves out of the object to be investigated. According to this solution briefly discussed above, parts of the human body, which are not to be investigated, are unnecessarily exposed to RF fields. Particularly the head or the feet of the patient on the entry side of the travelling-waves to be coupled into the tubular hollow interior are exposed, which is not necessary, if they are not to be examined. By means of the coaxial arrangement of the MRI device according to the present invention, the excitation and the deposition of energy is limited to the area of investigation to which according to the present invention the RF field is directed only. The area of investigation is variable and preferably is chosen such that as shown in the accompanying drawings the target area within the human body is being exposed to the RF field. The length of the area of investigation according to the present invention is variable as well, i.e. the gap between the two halves of the separated inner conductive member is variable, i.e. said members are moved towards one another in axial direction or are moved away with respect to one another in axial direction. The coaxial arrangement comes along with the additional advantage that there is no lower limiting frequency existing due to the geometry of the coaxial arrangement, so that the coaxial arrangement is operable with each frequency, concerning MRI. This offers the opportunity to use different nuclei MRI MRS respectively, such as 1 H, 23 Na, 31 P, 13 C, 3 He, 7 Li or 17 O, to name but a few, with one and the same device. In the past for each of the different nuclei a variety of different antenna systems, such as RF coils, have been necessary which now can be disposed of. This allows that with one and the same coaxial arrangement according to the present invention, for example MR imaging of a variety of nuclei, offering the advantage in turn, that the patients exposed to MR imaging with different nuclei can stay in their position, consequently are not to be moved from one MR device to another. The images to be taken with the arrangement according to the present invention are co-registered intrinsically.

Still further out of the volume, i.e. the part of the human body to be investigated and disposed to the RF field, no further RF excitation is applicable, so that imaging artefacts are being suppressed. By restricting spin excitation as well as signal reception to the area to be investigated, imaging artefacts and background noise from the excluded parts of the object to be investigated is minimized. Background noise results from noise from not excited sections as well as from excited sections outside of the investigation area.

### Brief description of the drawing

The present invention is described below by use of a set of drawings showing different embodiments of the present invention.
- Figure 1: shows a principle schematic view of the principle arrangement according to the present invention with an object to be investigated, i.e. the middle portion of a human body;
- Figure 2: shows a perspective view of a human body, the middle portion of which is to be investigated.
- Figure 3: shows electrical components connected to said MRT device according to the present invention.

### Preferred embodiments

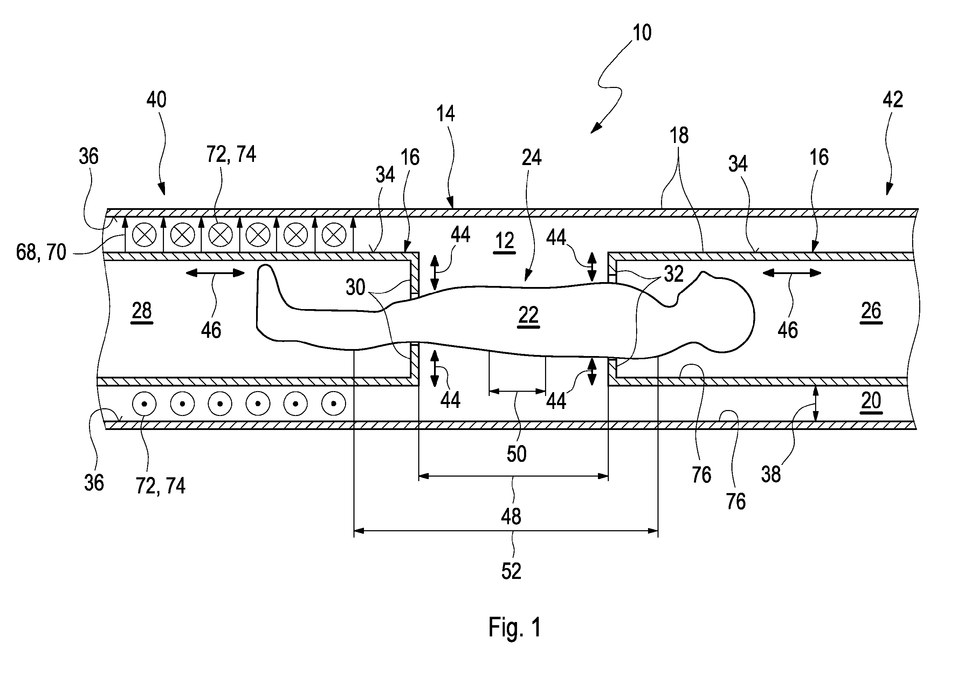

Figure 1 shows in a schematic view only an MRT device having a coaxial tubular arrangement 18 of a first outer conductive member, which extends without any interruption continuously in axial direction. The first outer conductive member 14 surrounds a second inner conductive member, which comprises two halves defining an investigation area 24. The two halves of the inner second conductive member 16 are arranged within the hollow interior 12 to be limited by the continuous outer first conductive member 14. As shown in Figure 1, the first outer conductive member 14 and the second conductive member 16 are spaced apart in radial direction by an annular space labelled reference numeral 38. The width of the annular space between the circumferences of the first conductive member 14 and the second conductive member 16, respectively, can be as small as a few centimetres.

As shown in Figure 1, the investigation area 24 is defined by the distance between the two adjacent halves of the second inner conductive member 16. In the invention according to Figure 1, the subject/object 22 to be investigated is a human body, for example the middle portion of which is located in the investigation area 24. The parts of the human body 22, which are not located within the investigation area 24, are excluded from exposition to RF fields by the walls of the second inner conductive member 16 in the first compartment 26 and the second compartment 28.

The travelling-waves being coupled into the coaxial arrangement 18 according to the present invention travel to said annular space 20 having a ring width 38 defined by the outer walls of the first and second compartment 26, 28, respectively, of the second inner conductive member and being limited by the inner wall of the first continuously extending outer conductive member 14. Thus, both portions of the object 22, i.e. in this case the human body, which are located within the compartment 26, 28, respectively, are excluded from exposition to RF fields.

As shown in Figure 1, said compartment 26, 28, respectively, are being defined by axial conductive surfaces 30, 32, respectively, which are moveable into radial direction as indicated by the double arrows 44. Thus, the axial conductive surfaces 30, 32, respectively, can be adapted in radial direction to different sizes of object 22 to be investigated. Still further, the investigation area 24 substantially defined by the axial positions of the conductive surfaces 30, 32, is variable in axial direction as well as indicated by the double arrows 48, 50, 52, respectively. By axial movement into axial directions of the compartment 26, 28 of the second inner conductive member 16 a first length 50 or a second length 52 of the investigation area 24 seen in axial direction thereof can be performed.

Still further, the varying of the length of the investigation area 24, i.e. in which the middle portion of the human body, i.e. the subject 22, to be investigated is located, allows for a guiding of the RF waves into the region of interest, which can be narrowed to particularly small regions of interest, where a RF field is to be coupled into the subject 22 to be investigated, i.e. into special areas of interest of the human subject 22 as shown in Figure 1.

The travelling-wave is coupled in at one end of the respective coaxial tubular arrangement 18 and the structure is being excited in the TEM mode, i.e. transversal electromagnetic mode. Both components, i.e. the electrical field E and the magnetic field M, respectively, are oriented perpendicular to one another with respect to the propagation direction. TEM is the native transition mode within a coaxial conductor. The vectors of the electrical field are oriented in radial direction between the circumference of the inner second conductive member 16 directed to the first continuous conductive member perpendicular to the orientation of the electrical field, the vectors of the magnetic field 72 are directed in circular direction 74 within the annular space 20 between the first and second conductive members 14, 16, respectively. Depending of the absolute diameters of the conductors, additional wave propagation of other modes, i.e. TE and TM modes, may be possible beside the TEM mode propagation. The compartment 26, 28 being defined by the axial conductive surfaces 30, 32 and the respective wall sections of the second coaxial conductive surface 32 are substantially free of RF fields. The coupling in of the travelling-wave, i.e. coupling in of the RF field, into the object to be investigated occurs in the gap, i.e. the investigation area 24. The transmission of the wave across the interruption is being performed by induced currents and Maxwell currents within the object or subject 22 as well as by means of Maxwell currents only in free space. The object 22 to be investigated is being penetrated by the travelling-wave and the nuclei are being excited. During excitation, travelling waves being transmitted across the investigation area 24 are being guided to the other end of the coaxial arrangement 18 and are being coupled out free of reflections. After excitation the resulting MR-signal, which is being emitted by the excited object 22, is being guided to both ends of coaxial arrangement, of which at least one is equipped with a receiving unit. All components of the coaxial tubular arrangement 18 according to the present invention comprise at least one layer of conductive material, for example copper, to allow for transition of the wave.

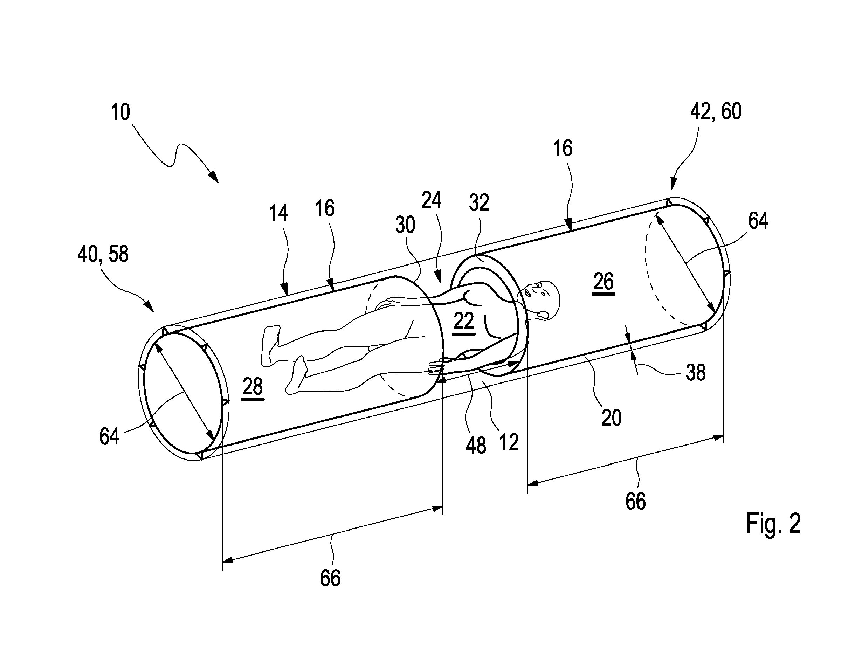

In Figure 2 a human subject 22 is shown in a perspective view, the head of the human subject 22 to be investigated being located in the first compartment 26, the legs and feet of the human subject 22 to be investigated, being enclosed in the interior of the second compartment 28. Said first compartment 26 and said second compartment 28 are arranged adjacent with respect to one another forming between said first axial conductive surface 30 and said second axial conductive surface 32, respectively, the investigation area 24. The inner diameter of said compartments 26, 28, respectively, is labelled with reference numeral 64, the respective compartment length of said compartment 26, 28, respectively, is labelled with reference numeral 66.

The variable length 48 of said investigation area 24 exposing the middle portion of the human subject 22 to be investigated to the RF field 72 is indicated by reference numeral 48. As described previously in connection with Figure 1, said length 48 between the axial conductive surface 30, 32 of said compartment 26, 28, respectively, can be varied in axial direction to create a larger or smaller middle portion, which is exposed to the RF field. Said coaxial arrangement 18 according to the perspective view in Figure 2 comprises a first end portion 40 and a second end portion 42, respectively. The first end portion 40 may include an insertion end 58, where the travelling-wave, i.e. the RF field, is to be coupled in to the coaxial arrangement 18 according to the present invention. The second end portion 42 according to the perspective view in Figure 2 comprises a dissipating end 60, where the travelling-waves are leaving the coaxial arrangement 18. Reference numeral 38 indicates said ring width of the annular space 20 between an inner wall of said first outer conductive member 14 and the outer circumference of the second inner conductive member 16 limiting said compartments 26, 28.

The Larmor frequency of protons is about 300 MHz at a magnetic field strength of about 7 T. The wavelength in air is 1 m at a frequency of 300 MHz. The wavelength is dependent on the medium in which the wave is propagating. In human tissue the wave length is to about 10 cm given at a frequency of 300 MHz.

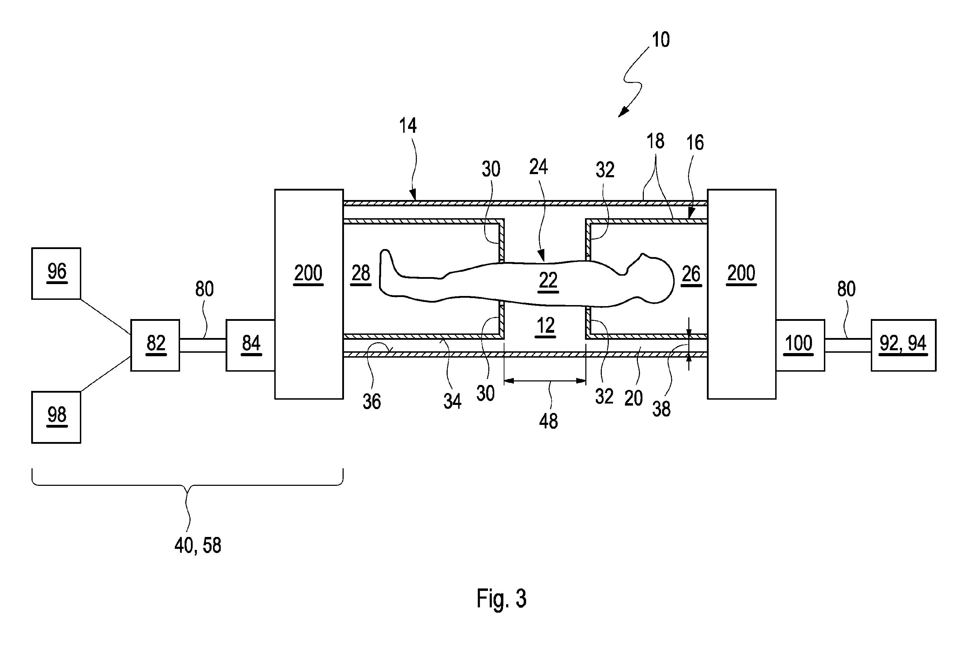

Figure 3 shows an embodiment of the present invention according to which by means of a coaxial cable 80 travelling waves are sent and directed via a transmit/receive switch. By means of said transmit/receive switch 82 a bi-directional operating mode is achieved. After a first impedance matching network 84 the first transition section 200 is located. This electrical/mechanical transition can realized in various ways, e.g. by one or more coaxial cables or by a double funnel shaped structure, which continuously extends its diameters from those of a coaxial cable to those of the coaxial arrangement 18.

At the second end portion 42, i.e. the dissipating end 60, said travelling wave is dissipated, i.e. coupled out free of reflections via a second impedance matching device 100 and a section of a coaxial cable 80 to an energy dissipating device 92 or a second receiver 94.

The middle portion of the human subject 22 is exposed to the RF field within the investigation area 24. Said investigation area 24 has a variable length 48 according to the dotted double arrow, which is variable between a first length 50 shorter than said variable length 48 as indicated in Figure 3, and for example a second length 52 exceeding said variable length 48 as shown in Figure 3. As already described in connection with Figure 1, said second inner conductive member 16, which defines the investigation area 24, comprises a first compartment 26 and a second compartment 28. Said compartments 26, 28 enclose the head, part of the legs and the feet of the human subject 22, that are not to be exposed to the RF field. The travelling waves entering said coaxial arrangement 18 at the first end portion 40, i.e. the insertion end 58, propagates through said annular space 20 established between the parallel extending conductive members 14, 16, respectively, in axial direction as well Figure 3 shows electrical components connected to said coaxial tubular arrangement 18 according to the present invention. As can be derived from Figure 3 by means of said transmit/receive switch 82 either a transmitter 96 generates waves to be coupled in into said coaxial cable 80 or in the alternative a receiver unit 98 is active and obtains signals from the travelling through said coaxial cable 80. As shown in Figure 3, a first impedance matching network 84 is arranged behind said transmit/receive switch 82. At the other end of said coaxial tubular arrangement 18 according to the present invention, another transition section 200 as well as another impedance matching network 100 connect the coaxial arrangement to a second reflection-free receiver 94 or another energy dissipating device 92.

Reference numeral list
- 10: MRT device
- 12: hollow interior
- 14: first outer conductive member
- 16: second inner conductive member
- 18: coaxial tubular arrangement
- 20: annular space
- 22: subject/object to be investigated
- 24: investigation area
- 26: second compartment
- 28: first compartment
- 30: first axial conductive surface
- 32: second axial conductive surface
- 34: outer mandrel of second conductive member 16
- 36: inner mandrel of first conductive member 14
- 38: ring width
- 40: first end portion
- 42: second end portion
- 44: vertical movement of shielding
- 46: horizontal movement of compartment
- 48: variable length of investigation area
- 50: first length
- 52: second length
- 58: insertion end
- 60: dissipating end
- 64: inner diameter of compartments 26,28
- 66: compartment length
- 68: electrical field
- 70: vector orientation of electrical field

## Claims

1. Apparatus for magnetic resonance imaging having a cavity (12) for placing therein a subject or object (22) to be imaged, means for applying a static magnetic field, means for applying gradient magnetic fields and means for coupling in electromagnetic excitation pulses having a predetermined operating frequency to induce nuclear magnetic resonance within the subject or object (22) and means for detecting an electromagnetic signal resulting from said magnetic resonance, wherein said object or subject (22) to be imaged is placed partially exposed only in an investigation area (24) within a coaxial tubular arrangement (18) having a first and a second conductive member (14, 16).

2. Apparatus according to claim 1, wherein said first conductive member (14) and said second conductive member (16) are separated from one another by an annular space (20).

3. Apparatus according to one or more of the preceding claims, wherein the magnetic field (72) is coupled in to said investigation area (24) by at least one travelling-wave (82).

4. Apparatus according to one or more of the preceding claims, wherein said annular space (20) and the investigation area (24) are filled with air or a dielectric medium, partially or entirely.

5. Apparatus according to one or more of the preceding claims, wherein said first conductive member (14) extends continuously from a first end portion (40) to a second end portion (42).

6. Apparatus according to one or more of the preceding claims, wherein said first conductive member (14) and said second conductive member (16) of the coaxial tubular arrangement (18) each comprises at least one conductive layer.

7. Apparatus according to one or more of the preceding claims, wherein said investigation area (24) is defined by a gap between adjacent compartments (26, 28) between said inner conductive members (16).

8. Apparatus according to one or more of the preceding claims, wherein said investigation area (24) has a variable length (48, 50, 52) seen in axial direction.

9. Apparatus according to one or more of the preceding claims, wherein said compartment (26, 28) each comprises conductive surfaces (30, 32), respectively, defining openings for the object or subject (22) to be investigated.

10. Apparatus according to one or more of the preceding claims, wherein said openings in said conductive surfaces (30, 32) are variable in width with respect to radial direction.

11. Apparatus according to one or more of the preceding claims, wherein said coaxial arrangement (18) includes at its end portions (40, 42) transition sections (86, 90).

12. Apparatus according to one or more of the preceding claims, wherein said coaxial arrangement (18) comprises a transmit/receive switch at said respective end portions (40, 42), respectively.

13. Apparatus according to one or more of the preceding claims, wherein said coaxial arrangement (18) comprises at its dissipating end (60) either a reflection-free material, particularly an absorbing material or a receiver (94) or another energy dissipating device (92).

14. Apparatus according to one or more of the preceding claims, wherein said at least on travelling-wave (82) is coupled in at an insertion end (58) of said coaxial arrangement and propagates through said annular space (20) to the opposite end (40, 42) and vice-versa.

15. Apparatus according to one or more of the preceding claims, wherein said coaxial arrangement (18) is being supplied by at least one wave generating device.

16. Apparatus according to one or more of the preceding claims, wherein said coaxial arrangement (18) comprises at least one receiving unit (94, 98) assigned to a transmit/receive switch (82) via an impedance matching network (84, 100), respectively.

17. Apparatus according to one or more of the preceding claims, wherein said coaxial tubular arrangement (18) is being operated with one or more frequencies in a simultaneous or subsequent mode.

18. Method for magnetic resonance imaging with a coaxial arrangement (18) with a first conductive member (14) and a second conductive member (16), defining a hollow interior (12) according to one or more of the preceding claims with the following method steps:
a) coupling in at least one travelling-wave (82) at one respective end portion (40, 42) of said coaxial arrangement (18),
b) propagating said at least one travelling-wave (82) to an investigation area (24) within a hollow interior (12) and
c) receiving said at least one travelling-wave (82) at a reflection-free termination (92) or a second receiver (94) assigned to said coaxial arrangement.

19. Method according to claim 18, wherein unexposed portions or sections of the subject or object (22) to be investigated are shielded against exposure in at least one compartment (26, 28).

20. Method according to claim 19, wherein said investigation area (24) is variable with respect to its length (48).

21. Method according to one or more of the preceding claims, wherein magnetic resonance imaging is performed using any MR responsive nuclei, e.g. 1 H, 23 Na, 31 B, 13 C, 3 He, 7 Li und 17 O.
